# FASCICULE DE BREVET EUROPEEN

(11) **EP 2 446 534 B1**
(45) Date de publication et mention de la délivrance du brevet: **07.01.2015**
(21) Numéro de dépôt: 10752360.7
(22) Date de dépôt: 21.06.2010
(51) Int. Cl.: H03H 11/26

(54) **DISPOSITIF À TRÈS HAUTE PRÉCISION DE MESURE DU TEMPS D'ARRIVÉE D'UN SIGNAL**
ULTRAHOCHPRÄZISE VORRICHTUNG ZUR MESSUNG DER ZEIT EINES SIGNALEINGANGS
VERY HIGH PRECISION DEVICE FOR MEASURING THE TIME A SIGNAL IS INPUT

(30) Priorité: 22.06.2009 FR 0954226
(43) Date de publication de la demande: 02.05.2012
(73) Titulaire: Centre National de la Recherche Scientifique (CNRS), 75016 Paris (FR); Commissariat à l'Énergie Atomique et aux Énergies Alternatives, 75015 Paris (FR); Université Paris-Sud, 91405 Orsay Cedex (FR)
(72) Inventeur: BRETON, Dominique, F-91190 Gif sur Yvette (FR); DELAGNES, Eric, F-92370 Chaville (FR); GENAT, Jean-François, F-92100 Boulogne-Billancourt (FR)
(74) Mandataire: Blot, Philippe Robert Emile
(86) Numéro de dépôt international: PCT/FR2010/051258
(87) Numéro de publication internationale: WO 2010/149920

(56) Documents cités:
- US-A- 4 439 046
- US-A- 5 619 445
- NORHUZAIMIN J ET AL: "The Design of High Speed UART", APPLIED ELECTROMAGNETICS, 2005. APACE 2005. ASIA-PACIFIC CONFERENCE ON JOHOR, MALAYSIA 20-21 DEC. 2005, PISCATAWAY, NJ, USA,IEEE LNKD- DOI:10.1109/APACE.2005.1607831, 20 décembre 2005 (2005-12-20), pages 306-310, XP010903062, ISBN: 978-0-7803-9431-5

## Description

La présente invention concerne un dispositif de mesure du temps d'arrivée d'un signal.

Dans la suite de la présente, le terme « signal » est utilisé pour désigner un signal analogique ou numérique et un signal numérique sera traité de la même façon qu'un signal analogique.

Plus particulièrement, l'invention se rapporte à un tel dispositif de mesure de temps (TDC) à très haute précision, connu de l'état de l'art et basé sur l'utilisation d'un compteur cadencé par une horloge et associé à une ligne à retard comportant plusieurs éléments à retard élémentaires, par exemple égaux en durée (voir US 4 439 046). Par exemple, une telle ligne à retard peut comporter D éléments à retard d'une durée égale à td.

La somme des retards élémentaires D x td peut être asservie à la période d'horloge. Dans un autre cas, elle doit être régulièrement calibrée.

Des retards élémentaires supplémentaires sont parfois utilisés, le plus souvent pour compenser des effets de bord.

Ainsi et dans un tel dispositif, le signal d'entrée est tout d'abord converti en impulsion binaire par des moyens formant convertisseur basés par exemple sur l'utilisation d'un discriminateur.

Dans son mode de réalisation le plus simple, ce discriminateur peut par exemple être un simple comparateur comparant le signal d'entrée à une valeur de seuil fixe. Cependant, pour obtenir une datation correcte, ce discriminateur est souvent un dispositif plus complexe dont le temps de propagation doit être bien maîtrisé.

La mesure de temps est alors réalisée sur le signal binaire délivré par le discriminateur par l'ensemble comprenant le compteur et la ligne à retard.

A l'arrivée de l'impulsion de sortie du discriminateur, ou lors de l'un des fronts d'horloge suivants, le compteur et la ligne à retard sont soit stoppés, soit recopiés dans un autre registre ou élément à mémoire.

La ligne à retard donne alors la partie fine de la mesure de temps à l'intérieur de la période d'horloge en complément du compteur.

Ce dispositif présente cependant deux inconvénients majeurs, à savoir :
1. le discriminateur a un temps de réaction dépendant de la forme et de l'amplitude du signal d'entrée ainsi que du seuil de discrimination,
2. le pas de mesure de temps est celui de la ligne à retard, limité au premier ordre par la technologie microélectronique choisie pour le circuit correspondant.

De nombreuses améliorations de ce type de dispositifs ont déjà été proposées dans l'état de la technique.

Ainsi par exemple et pour ce qui concerne le discriminateur, l'utilisation d'un discriminateur à fraction constante permet de rendre au premier ordre le temps de propagation indépendant de l'amplitude du signal. Mais ceci ne fonctionne que sur des signaux homothétiques en amplitude. De plus l'intégration d'un tel discriminateur dans un circuit de type ASIC présente de grandes difficultés.

Les améliorations liées aux lignes à retard font, pour la plupart, appel à une interpolation entre plusieurs d'entre elles. Bien que ces solutions apportent un gain appréciable en précision, elles présentent également un certain nombre d'inconvénients majeurs, parmi lesquels :
1. une complexité de leur principe de fonctionnement et de leur réalisation pratique,
2. une augmentation de la surface nécessaire à l'implémentation physique et de la consommation liées aux lignes à retard supplémentaires, et
3. la nécessité en général d'une calibration lourde et fréquente.

On notera qu'il est possible de minimiser le temps mort lié à l'acquisition d'un tel dispositif en remplaçant par exemple les registres dans lesquels sont copiés les états du compteur et de la ligne à retard par des mémoires de type FIFO à double port par exemple. L'intégration microélectronique multivoies de ce type de dispositifs se fait de façon classique.

De façon pratique, la résolution de ce type de dispositifs est limitée à quelques dizaines de picosecondes rms.

De façon alternative, la partie de datation fine du dispositif de mesure peut être remplacée par un convertisseur temps amplitude réalisé par un générateur de rampe de tension démarré par la sortie du discriminateur et stoppé par l'horloge. Cette tension numérisée par un convertisseur analogique numérique (ADC) est une image du temps fin. Le pas de datation fin du dispositif ne dépend ici que de la pente de la rampe et du pas de l'ADC. La rapidité de la technologie microélectronique utilisée n'apparait pas ici comme une limitation à la résolution.

Par contre, la résolution de ce type de dispositifs est limitée par le bruit sur la rampe, sa linéarité et par la précision (et les artefacts) du démarrage et de l'arrêt du générateur de rampe. Si bien que dans sa version intégrée, la résolution temporelle (du dispositif de mesure seul) est au mieux de l'ordre de 10ps rms. Cette implémentation est par contre défavorable en terme de temps mort et nécessite également une calibration qui peut s'avérer complexe.

Le but de l'invention est donc de résoudre les problèmes liées aux dispositifs préexistants.

A cet effet, l'invention a pour objet un dispositif de mesure du temps d'arrivée d'un signal d'entrée, du type comportant des moyens de conversion du signal d'entrée en impulsion binaire, dont la sortie est raccordée à des moyens formant compteur et à des moyens formant ligne à retard comportant plusieurs éléments à retard, les moyens formant compteur et les moyens formant ligne à retard recevant également en entrée un signal d'horloge, caractérisé en ce que les moyens formant ligne à retard sont associés à des moyens formant échantillonneur et mémoire analogique comportant plusieurs cellules de mémorisation, recevant en entrée le signal d'entrée et en ce que chaque élément des moyens formant ligne à retard présente une sortie raccordée à une cellule de mémorisation correspondante des moyens formant mémoire analogique pour piloter de façon séquentielle l'échantillonnage et la mémorisation du signal d'entrée dans ceux-ci.

Selon d'autres aspects de l'invention, le dispositif de mesure du temps comprend l'une ou plusieurs des caractéristiques suivantes :
- les moyens formant ligne à retard sont asservis en durée et en phase à la période de l'horloge ou à l'un de ses multiples.
- les moyens formant mémoire analogique sont associés en sortie à au moins un convertisseur analogique-numérique,
- des moyens à retard sont interposés entre les moyens de conversion d'une part et les moyens formant compteur et les moyens formant ligne à retard d'autre part,
- les moyens de conversion comprennent un discriminateur comportant un comparateur du signal d'entrée à une valeur de seuil fixe, et
- les moyens de conversion comprennent un discriminateur à temps de propagation maîtrisé.

L'invention sera mieux comprise à l'aide de la description qui va suivre, donnée uniquement à titre d'exemple et faite en se référant aux dessins annexés, sur lesquels :
- la figure 1 représente un schéma synoptique illustrant la structure et le fonctionnement d'un dispositif de mesure de l'état de la technique,
- la figure 2 représente un schéma synoptique illustrant la structure et le fonctionnement d'un dispositif de mesure selon l'invention, et
- la figure 3 représente différents signaux illustrant le fonctionnement d'un dispositif de mesure selon l'invention.

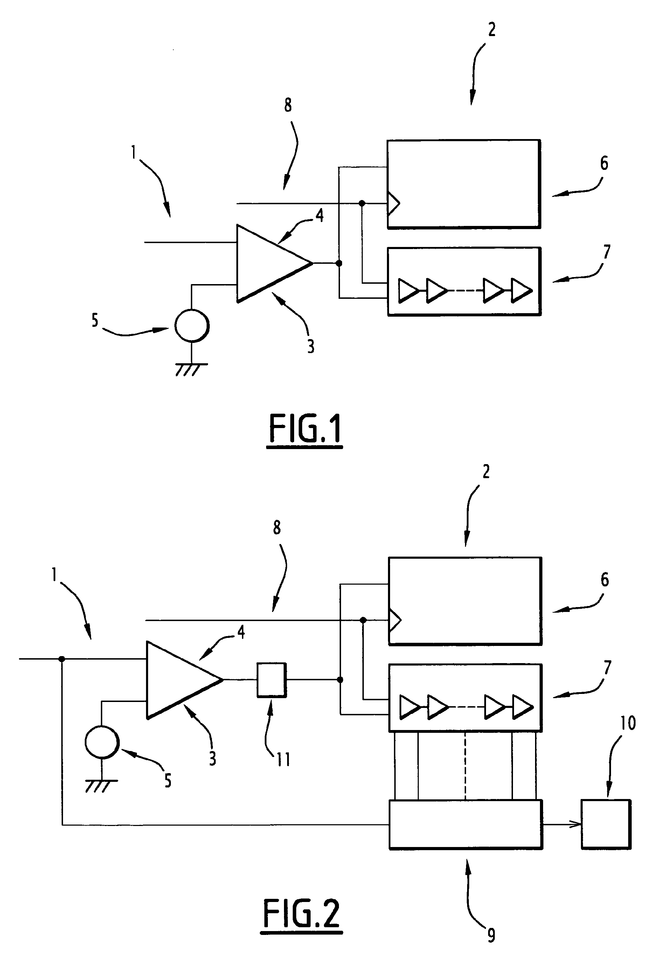

On reconnaît en effet sur la figure 1, un dispositif de mesure du temps d'arrivée d'un signal d'entrée, le signal d'entrée étant désigné par la référence générale 1 sur cette figure et le dispositif de mesure étant désigné par la référence générale 2.

Comme cela a été indiqué précédemment, un tel dispositif comporte des moyens de conversion du signal d'entrée en impulsion binaire, ces moyens étant désignés par la référence générale 3 et comportant par exemple un discriminateur à base de comparateur dans le mode de réalisation le plus simple, désigné par la référence générale 4, adapté pour comparer le signal d'entrée 1 à une valeur de seuil par exemple fixe, telle que délivrée par des moyens correspondants désignés par la référence générale 5.

La sortie du discriminateur 4 est alors une impulsion binaire d'arrêt ou de copie qui est alors délivrée en sortie du comparateur à des moyens formant compteur désignés par la référence générale 6 et à des moyens formant ligne à retard comportant plusieurs éléments à retard et désignés par la référence générale 7.

Ces moyens formant compteur et ligne à retard reçoivent également en entrée un signal d'horloge désigné par la référence générale 8 sur cette figure.

Le principe du fonctionnement de ce dispositif a été décrit dans le préambule de la description.

On a illustré sur la figure 2, un schéma synoptique d'un exemple de réalisation d'un dispositif de mesure selon l'invention qui permet de résoudre les problèmes évoqués.

Sur cette figure 2, des éléments identiques ou analogues à ceux déjà décrits en regard de la figure 1, sont désignés par les mêmes références.

C'est ainsi que l'on reconnaît sur cette figure 2, le signal d'entrée 1, le dispositif de mesure 2, les moyens de conversion 3 et le comparateur 4, de même que les moyens 5 de fixation de la valeur de seuil, les moyens formant compteur 6, les moyens formant ligne à retard 7 et le signal d'horloge 8.

Les moyens formant ligne à retard 7 sont asservis en durée et en phase à la période de l'horloge ou à l'un de ses multiples.

Pour résoudre les problèmes décrits précédemment, dans le dispositif de mesure selon l'invention, les moyens formant ligne à retard 7 sont associés à des moyens formant échantillonneur et mémoire analogique comportant plusieurs cellules de mémorisation, et désignés par la référence générale 9 sur cette figure 2.

Ces moyens formant échantillonneur et mémoire analogique 9 reçoivent en entrée le signal d'entrée 1 et présentent n'importe quelle structure classique appropriée.

De plus, chaque élément des moyens formant ligne à retard présente une sortie raccordée à une cellule de mémoire correspondante des moyens formant échantillonneur et mémoire analogique pour piloter de façon séquentielle l'échantillonnage et la mémorisation du signal d'entrée dans ceux-ci.

Au moins un convertisseur analogique-numérique désigné par la référence générale 10 peut être associé à la sortie des moyens formant échantillonneur et mémoire analogique 9.

De plus, des moyens à retard désignés par la référence générale 11, peuvent être interposés entre les moyens de conversion 3 d'une part et les moyens formant compteur 6 et les moyens formant ligne à retard 7 d'autre part.

Une telle structure permet de résoudre les différents problèmes évoqués précédemment de manière très simple.

En effet, dans cette structure, chaque pas de la ligne à retard est associé à une cellule mémoire qui échantillonne à une fréquence égale à l'inverse du pas de ladite ligne à retard et enregistre de façon analogique le signal d'entrée brut (non discriminé).

Lors de la phase d'acquisition, les sorties des pas de la ligne à retard commandent alors de façon séquentielle l'échantillonnage et la mémorisation du signal d'entrée de façon analogique dans les cellules mémoire associées.

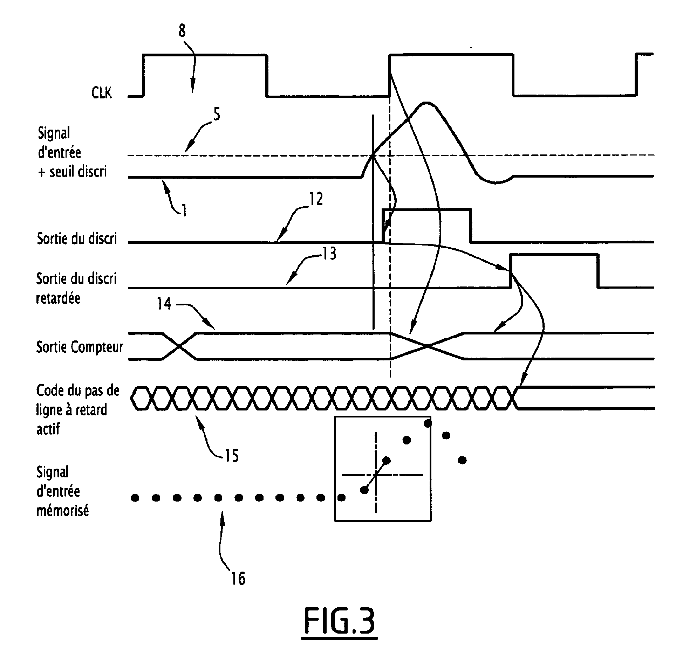

L'impulsion de sortie du discriminateur 4, du fait de son temps de réaction fini, présente un certain retard sur la ligne d'entrée, comme cela est illustré sur la figure 3. Cette impulsion arrête alors l'échantillonnage dans la mémoire analogique et initie simultanément la prise de temps numérique (arrêt ou recopie de l'ensemble compteur et ligne à retard). Si nécessaire, ce retard peut être volontairement allongé pour assurer la capture complète du signal. Dans ce cas, le compteur et la ligne à retard sont recopiés ou stoppés sur la base de l'impulsion retardée. La ligne à retard peut même être volontairement rallongée pour cet usage.

Il est à noter que cette structure fait que la reproductibilité et la précision de ces différents retards n'interviennent pas dans la précision de la mesure qui n'est liée qu'à celle de l'échantillonnage dans la mémoire analogique.

Les cellules mémoire contiennent alors la forme d'onde du signal d'entrée échantillonnée de façon analogique sur un intervalle de temps contemporain à la montée de l'impulsion binaire de sortie du discriminateur.

Cette forme d'onde permet, grâce à un traitement numérique des données analogiques enregistrées, d'affiner la mesure de temps réalisée de façon grossière par le compteur.

Pour cela, cette forme d'onde est tout d'abord numérisée par un convertisseur analogique-numérique tel que le convertisseur 10, avant d'appliquer des techniques adaptées d'analyse numérique, de façon classique.

Cette façon de procéder permet d'obtenir une précision bien au-delà de celle du pas d'échantillonnage de la ligne à retard, typiquement de l'ordre de 1 à 2 ordres de grandeur.

L'absence de mise en forme du signal échantillonné permet d'éviter toute gigue liée à celle-ci ou à l'opération de discrimination analogique.

Le discriminateur reste néanmoins nécessaire afin de stopper l'enregistrement du signal, mais la précision en temps demandée à celui-ci est relâchée car elle n'entre plus en compte dans la précision finale de la mesure. Dans cette solution, le nombre d'éléments critiques de la chaîne est donc drastiquement réduit. Les seuls paramètres critiques qui subsistent sont la bande passante et le rapport signal sur bruit de la partie analogique du système. Cependant, et ceci uniquement afin de limiter la profondeur d'enregistrement nécessaire, un discriminateur à temps de propagation maîtrisé tel qu'un discriminateur à fraction constante peut également être utilisé avec toutefois les difficultés d'intégration mentionnées précédemment.

Dans le dispositif selon l'invention, comme dans les dispositifs de l'état de la technique, le problème de synchronisation et de gestion de la métastabilité potentielle entre le compteur et la ligne à retard reste posé et peut être résolu de façon classique car il est uniquement lié à l'arrêt ou à la copie de la ligne à retard et du compteur.

Ceci est illustré sur la figure 3, où l'on reconnaît en effet le signal d'horloge 8, le signal d'entrée 1, la valeur de seuil fixe délivrée par les moyens 5, et la sortie du discriminateur 4 désignée par la référence générale 12 sur cette figure, avant passage dans les moyens à retard 11. La sortie de ces moyens à retard est alors désignée par la référence générale 13 s'ils sont utilisés. En 14, on a illustré la sortie du compteur 6 et en 15 le code du pas de la ligne à retard actif 7. Enfin, en 16, on a illustré le signal d'entrée mémorisé dans les moyens formant mémoire analogique 9 et plus particulièrement dans les différentes cellules de ceux-ci. Ce signal se présente alors sous la forme d'échantillons analogiques. Ces échantillons sont utilisables pour extraire un temps fin par interpolation, comme cela est illustré, la précision obtenue étant liée au rapport signal sur bruit des échantillons analogiques, au nombre d'entre eux utilisés pour le calcul et à la puissance de l'algorithme d'interpolation.

On notera qu'une simple interpolation linéaire donne déjà d'excellents résultats, en particulier si la fréquence d'échantillonnage est très supérieure à la bande passante. Un algorithme de calcul reproduisant un discriminateur à fraction constante peut encore améliorer la précision de mesure. Des calculs basés sur la corrélation croisée avec un signal de référence peuvent encore permettre d'affiner le résultat car ils permettent de s'abstraire en partie du bruit sur le signal. Ce type de traitement numérique du signal est bien connu de l'homme de l'art et ne sera pas décrit plus en détails par la suite.

Il va de soi bien entendu, que d'autres modes de réalisation peuvent également être envisagés.

Dans le cadre de cette invention comme dans les solutions classiques, il est possible de travailler sans temps mort en utilisant une banque comprenant plusieurs ensembles ligne à retard plus compteur utilisés alternativement.

## Revendications

1. Dispositif de mesure du temps d'arrivée d'un signal, du type comportant des moyens (3, 4) de conversion du signal d'entrée (1) en impulsion binaire, dont la sortie est raccordée à des moyens formant compteur (6) et à des moyens formant ligne à retard (7) comportant plusieurs éléments à retard, les moyens formant compteur (6) et les moyens formant ligne à retard (7) recevant également en entrée un signal d'horloge (8), **caractérisé en ce que** les moyens formant ligne à retard (7) sont associés à des moyens formant échantillonneur et mémoire analogique (9) comportant plusieurs cellules de mémorisation, recevant en entrée le signal d'entrée (1) et **en ce que** chaque élément des moyens formant ligne à retard (7) présente une sortie raccordée à une cellule de mémorisation correspondante des moyens formant mémoire analogique (9) pour piloter de façon séquentielle l'échantillonnage et la mémorisation du signal d'entrée (1) dans ceux-ci.

2. Dispositif de mesure du temps d'arrivée d'un signal selon la revendication 1, **caractérisé en ce que** les moyens formant ligne à retard (7) sont asservis en durée et en phase à la période de l'horloge ou à l'un de ses multiples.

3. Dispositif de mesure du temps d'arrivée d'un signal selon la revendication 1 ou 2, **caractérisé en ce que** les moyens formant échantillonneur et mémoire analogique (9) sont associés en sortie à au moins un convertisseur analogique-numérique (10).

4. Dispositif de mesure du temps d'arrivée d'un signal selon l'une quelconque des revendications précédentes, **caractérisé en ce que** des moyens à retard (11) sont interposés entre les moyens de conversion (3) d'une part et les moyens formant compteur (6) et les moyens formant ligne à retard (7) d'autre part.

5. Dispositif de mesure du temps d'arrivée d'un signal selon l'une quelconque des revendications précédentes, **caractérisé en ce que** les moyens de conversion (3) comprennent un discriminateur (4) comportant un comparateur du signal d'entrée à une valeur de seuil fixe (5).

6. Dispositif de mesure du temps d'arrivée d'un signal d'entrée selon l'une quelconque des revendications 1 à 4, **caractérisé en ce que** les moyens de conversion (3) comprennent un discriminateur à temps de propagation maîtrisé.

## Patentansprüche

1. Vorrichtung zum Messen der Empfangszeit eines Signals von einem Typ, der Mittel (3, 4) zum Wandeln eines Binärimpuls-Eingangssignals (1) aufweist, deren Ausgang mit Mitteln (6), die einen Zähler bilden, und mit Mitteln (7), die eine Verzögerungsleitung, die mehrere Verzögerungselemente aufweist, bilden, verbunden ist, wobei die Mittel (6), die einen Zähler bilden und die Mittel(7), die eine Verzögerungsleitung bilden, am Eingang auch ein Taktsignal (8) empfangen, dadurch charakterisiert, dass die Mittel (7), die eine Verzögerungsleitung bilden, Mitteln, die einen Abtaster und einen analogen Speicher (9) bilden, der mehrere Speicherzellen aufweist, die am Eingang das Eingangssignal (1) empfangen, zugeordnet sind, und dadurch, dass jedes Element der Mittel (7), die eine Verzögerungsleitung bilden, einen Ausgang aufweist, der mit einer entsprechenden Speicherzelle der Mittel, die einen analogen Speicher (9) bilden, zum sequentiellen Steuern des Abtastens und des Speicherns des Eingangssignals (1) in ihnen verbunden ist.

2. Vorrichtung zum Messen der Empfangszeit eines Signals gemäß Anspruch 1, dadurch charakterisiert, dass die Mittel (7), die eine Verzögerungsleitung bilden, in der Dauer und der Phase durch die Taktperiode oder eines ihrer Vielfachen gesteuert werden.

3. Vorrichtung zum Messen der Empfangszeit eines Signals gemäß Anspruch 1 oder 2, dadurch charakterisiert, dass die Mittel, die einen Abtaster und einen analogen Speicher (9) bilden, ausgangsseitig mit mindestens einem Analog-Digital-Wandler (10) verbunden sind.

4. Vorrichtung zum Messen der Empfangszeit eines Signals gemäß einem der vorhergehenden Ansprüche, dadurch charakterisiert, dass Verzögerungsmittel (11) zwischen den Mittel zum Wandeln (3) einerseits und den Mitteln (6), die einen Zähler bilden, und den Mitteln (7), die eine Verzögerungsleitung bilden, andererseits geschaltet sind.

5. Vorrichtung zum Messen der Empfangszeit eines Signals gemäß einem der vorhergehenden Ansprüche, dadurch charakterisiert, dass die Mittel zum Wandeln (3) einen Diskriminator (4) aufweisen, der einen Vergleicher eines Eingangssignals mit einem festen Schwellwert (5) aufweist.

6. Vorrichtung zum Messen der Empfangszeit eines Signals gemäß einem der Ansprüche 1 bis 4, dadurch charakterisiert, dass die Mittel zum Wandeln (3) einen gesteuerten Ausbreitungszeitdiskriminator aufweisen.

## Claims

1. A device for measuring the time a signal is input, of the type comprising conversion means (3, 4) for converting the input signal (1) into binary pulses, the output of which is connected to counter means (6) and to delay line means (7) comprising a plurality of delay elements, the counter means (6) and the delay line means (7) receiving also a clock signal (8) in input, **characterised in that** the delay line means (7) are combined with means forming a sampler and analogue memory (9) comprising multiple storage cells, receiving in input the input signal (1) and **in that** each element of the delay line means (7) has an output connected to a corresponding storage cell of the analogue memory means (9) to sequentially drive the sampling and storage of the input signal (1) in the latter.

2. A device for measuring the time a signal is input according to claim 1, **characterised in that** the delay line means (7) are controlled in duration and phase by the clock period or one of its multiples.

3. A device for measuring the time a signal is input according to claim 1 or 2, **characterised in that** the sampler and analogue memory means (9) are associated in output with at least one analogue-digital converter (10).

4. A device for measuring the time a signal is input according to any one of the preceding claims, **characterised in that** the delay means (11) are interposed among the conversion means (3) on the one hand and the means counter means (6) and the delay line means (7) on the other hand.

5. A device for measuring the time a signal is input according to any one of the preceding claims, **characterised in that** the conversion means (3) comprise a discriminator (4) comprising a comparator of the input signal at a set threshold value (5).

6. A device for measuring the time a signal is input according to any one of claims 1 to 4, **characterised in that** the conversion means (3) comprise a controlled propagation time discriminator.
